# EUROPÄISCHE PATENTSCHRIFT

(11) **EP 1 291 921 B1**
(45) Veröffentlichungstag und Bekanntmachung des Hinweises auf die Patenterteilung: **13.08.2008**
(21) Anmeldenummer: 02012269.3
(22) Anmeldetag: 05.06.2002
(51) Int. Cl.: H01L 27/146

(54) **Beschaltungsverfahren für einen Halbleitersensor**
Method of operating a semiconductor sensor
Méthode d'opération d'un capteur à semi-conducteur

(30) Priorität: 29.06.2001 DE 10131420
(43) Veröffentlichungstag der Anmeldung: 12.03.2003
(73) Patentinhaber: Fink, Lutz, 21698 Issendorf (DE)
(72) Erfinder: Fink, Lutz, 21698 Issendorf (DE)
(74) Vertreter: Hansen, Jochen

(56) Entgegenhaltungen:
- EP-A- 0 836 217
- DE-C1- 19 927 694
- US-A- 5 396 072
- US-A- 5 877 594

## Beschreibung

Die Erfindung betrifft ein Verfahren zur Beschaltung eines Halbleitersensors mit einer Pixelstruktur gemäß den Ansprüchen 1 und 2. Das Beschaltungsverfahren eignet sich insbesondere zur Bilderfassung in optoelektronischen Anordnungen.

Ein derartiger Halbleitersensor ist beispielsweise aus der DE 199 27 694 C1 bekannt. Bei dieser Elektronen detektierenden Pixelstruktur ist der Halbleiter vor Elektronenbeschuß geschützt. Nachteilig an dieser Struktur ist, daß variable Empfindlichkeiten und ultraschnelle Auslesung von Bildinformationen nicht möglich sind. Bei bildgebenden Halbleitersensoren nach der CMOS-Technik ist zwar eine Ladungsabfrage über die Auslesestruktur beliebig in Reihenfolge und Zeitpunkt möglich, jedoch bedarf das Auslesen bestimmte Taktzeiten, die eine ultraschnelle Bildwiederholungsrate nicht zulassen.

Um eine ultrakurze Bildfolgezeit zu ermöglichen, ist es ferner bekannt, in einer sog. "Streak-Röhre" einen Elektronenstrom über ein Röhrenelement auf einen Leuchtschirm zu lenken, unter dem ein photosensitiver Bildsensor angeordnet ist. Dabei werden auf dem Bildsensor in schneller Folge Teilbilder abgebildet und erst nach erfolgtem Belichtungszyklus die Pixelinformationen aus dem Sensor ausgelesen. Nachteilig ist jedoch, daß dieser Sensor zunächst die elektrischen Signale in visuelle Signale und diese dann wiederum im Bildsensor in ein Videosignal wandelt. Der Sensor ist somit aufwendiger im Aufbau, bei der Herstellung und im Betrieb.

Ferner ist ein sog. "Duopixel-System" bekannt, wobei jeder Pixel eines photosensitiven Elementes als Doppelpixel ausgebildet ist und die Detektierung abwechselnd über den einen bzw. den anderen Pixel des Doppelpixels erfolgt. Mit dieser Ausführung kann jedoch nur eine geringfügige Bildfolgebeschleunigung erreicht werden.

Aus der US-A-5,396,072 ist ein Röntgenbilddetektor mit einer Pixelstruktur bekannt, wobei zu jedem Pixel eine Kapazität ausgebildet ist. Dabei sind auf der Halbleiterstruktur neben den Pixeln Schaltleitungen sowie Elektroden rechtwinklig zueinander ausgebildet. Dabei ist nachteilig, dass die Sammelelektroden, die die Pixelstruktur, also jeweils einen einzelnen Bildpunkt (Pixel), bilden, in der Dünnschichttechnik nicht die Schaltleitungen und insbesondere nicht die Ausgangsleitungen überdecken dürfen, weil sich dadurch große parasitäre Kapazitäten zwischen der Sammelelektrode und den betreffenden Elektroden bilden würden. Entsprechend müssen sich die Sammelelektroden also auf die zwischen zwei benachbarten Schaltleitungen bzw. zwei benachbarten Ausgangsleitungen verbleibende Fläche beschränken. Entsprechend umfasst bei dem Röntgenbilddetektor gemäß US-A-5,396,072 die Sammelelektroden je zwei in elektrischem Kontakt miteinander befindliche Elektrodenteile, wobei der erste Elektrodenteil jeweils in einem Bereich neben der Ausgangsleitung zur Vermeidung von parasitären Kapazitäten angeordnet ist und der zweite Elektrodenteil eine größere Fläche hat und sich zwischen zweitem Elektrodenteil und der Ausgangsladung eine Isolierschicht zur Vermeidung parasitärer Kapazitäten befindet. Es wird also die Sammelelektrode durch eine möglichst großflächige Elektrode, die miteinander kontaktiert sind (erster Elektrodenteil und zweiter Elektrodenteil), auf der Eingangsseite so weit vergrößert, dass der Abstand zwischen den einander zugewandten Kanten benachbarter Sammelelektroden zwischen 5 und 15 µm liegen kann, so dass das Verhältnis zwischen der Sammelelektrodenfläche und der für einen Bildpunkt zur Verfügung stehenden Fläche auch bei einer Bildpunktgröße von 100 µm noch bis zu 90 % betragen kann. Auch in einer zweiten Ausführungsform wird die wirksame Fläche des Halbleitersensors, nämlich der Pixeloberfläche vergrößert. Hier ist es eine halbleitende Schicht, die auf die isolierende **Schicht aufgebracht ist und mit den jeweiligen Sammelelektroden (Pixel)** kontaktiert ist. Dabei ist die halbleitende Schicht nur für positive Ladungsträger leitfähig.

Aus der EP 0 836 217 A1 ist eine Elektronenröhre mit einer Elektronenstrahlquelle zum Emittieren eines Elektrons durch ein elektrisches Feld und einer Anode zum Aufnehmen des von der Elektronenstrahlquelle emittierten Elektrons bekannt, wobei die Elektronenstrahlquelle eine Feldemissionsquelle aufweist, deren Form sich zur Anode hin verjüngt und wobei die Elektronenstrahlquelle aus Diamant oder einem vorwiegend aus Diamant zusammengesetzten Material besteht und eine mit Wasserstoff abgeschlossene Oberfläche aufweist, und wobei die Elektronenröhre eine geschlossene Umhüllung zur Aufnahme von wenigstens der Elektronenstrahlquelle und der Anode aufweist, wobei in der geschlossenen Umhüllung Wasserstoff mit einem Partialdruck im Bereich von 1,33 × 10⁻⁴ bis 1,33 × 10⁻¹ Pa eingeschlossen ist. Ferner hat die Elektronenröhre eine Fokussierelektrode zum Konvergieren der Flugbahn des von der Feldemissionsquelle emittierten Elektrons, wobei die Fokussierelektrode zwischen der Feldemissionsquelle und der Steuerelektrode angeordnet ist.

Ausgehend vom eingangs genannten Stand der Technik ist es daher Aufgabe, einen Halbleitersensor zum direkten Detektieren von Elektronen so auszubilden bzw. zu beschalten, daß eine variable Empfindlichkeit, Auflösung und/oder ultrakurze Bildfolgezeit ermöglicht wird.

Diese Aufgabe wird mit einem verfahren gemäß Anspruch 1 oder 2 gelöst. Weitere vorteilhafte Merkmale sind in den abhängigen Ansprüchen beschrieben.

In den nebengeordneten verfahrensgemäßen Ansprüchen 1 und 2 ist jeweils eine Bündelung der zu detektierenden Elektronen auf bestimmte Integrationselektroden (Registrierpixel) angegeben, einmal durch das Beschalten von bestimmten Integrationselektroden über eine Schalteinheit mit einem festen Potential oder durch das Vorsehen von gesonderten Fokussierelektroden, die ebenfalls an ein festes Potential gelegt werden.

Diese beiden Konstruktionsalternativen können in weiterer Ausgestaltung auch miteinander verbunden werden, wobei dann sowohl Fokussierelektroden mit einem angelegten Potential, wie auch ausgewählte Integrationselektroden, ebenfalls mit einem festen Potential, Potentialwälle und -töpfe an der Halbleiteroberfläche zur Bündelung des zu detektierenden Elektronenflusses ausbilden.

Je nach Beschaltung des an die Fokussierelektrode und/oder Integrationselektrode angelegten Potentials kann so der zu detektierende Elektronenfluß auf ausgewählte Bereiche der Pixelstruktur des Halbleitersensors gelenkt werden.

Beispielweise kann bei einem hochauflösenden Sensor von 1024 x 1024 Bildpunkten (Pixeln) für bestimmte Anwendungen eine Fokussierung des zu detektierenden Elektronenflusses auf den zentralen Pixel (Registrierpixel) von beispielsweise 3 x 3 = 9 Pixel erreicht werden. Damit reduziert sich die Datenmenge auf 1/9 und entsprechend erhöht sich die Empfindlichkeit des Sensors um Faktor 9. Durch die reduzierte Datenmenge ist auch die nachfolgende Datenverarbeitung entsprechend schneller durchzuführen.

Die Erhöhung der Empfindlichkeit ergibt sich daraus, daß durch das angelegte Fokussierpotential die normalerweise auf die in unserem Beispiel 9 Pixel verteilt auftreffenden Elektronen auf das ausgewählte Registrierpixel gebündelt werden.

Wenn die Fokussierelektroden und/oder Integrationselektroden mit der Schalteinheit derart verbunden sind, daß bedarfsweise unterschiedliche Potentiale an die Fokussierelektrode bzw. Integrationselektroden anlegbar sind, kann der zur Bündelung des Elektronenflusses ausgebildete Potentialtopf eine für den jeweiligen Bündelungszweck optimale Form erhalten.

Dadurch, daß die Fokussierelektrode mehrteilig ausgebildet und jedes Fokussierelektrodenelement mit einem Ausgang der Schalteinheit zur getrennten Beschaltung verbunden ist, wird die Beeinflussungsmöglichkeit des zur Bündelung erzeugten elektrischen Feldes im Raum oberhalb des Halbleiters weiter verbessert.

Für diesen Zweck können auch mehrere Fokussierelektroden konzentrisch um einen oder mehrere Integrationselektroden angeordnet werden.

Bei der Ausbildung der an die Fokussierelektrode anzulegenden Potentiale ist bei entsprechenden Halbleitersensoren die Auswirkung der vor dem Detektieren von Elektronen mit einem Reset-Potential aufzuladenden Integrationselektroden zu berücksichtigen. Die an die Fokussierelektroden festanzulegenden Potentiale müssen einen entsprechend fokussierenden Potentialtopf um den betreffenden Registrierpixel bilden, unabhängig vom jeweiligen Ladungszustand der Integrationselektrode des Registrierpixels zwischen Reset-Potential und durch Elektronenbeschuß entsprechend gemindertem Potential.

Dadurch, daß der zu detektierende Elektronenfluß, der auf eine vorher festgelegte Umgebung eines Pixels gerichtet ist, durch an die Fokussierelektroden angelegte feste Potentiale auf einem dieser Umgebung zugeordneten Registrierpixel gesammelt wird, wird eine Bündelung des Elektronenflusses auf ein ausgewähltes Registrierpixel und somit eine Empfindlichkeitssteigerung erreicht.

Wenn an die zur festgelegten Umgebung des Registrierpixels gehörenden Integrationselektroden der angrenzenden Pixel ein festes Potential angelegt wird, werden die zur momentanen Registrierung nicht benötigten Integrationselektroden ebenso wie die Fokussierelektroden zur Fokussierung des Elektronenflusses auf das Registrierpixel verwendet.

Dadurch, daß der zu detektierende Elektronenfluß innerhalb einer festgelegten Anzahl und Anordnung benachbarter Pixel je bildgebendem Vorgang in zeitlicher Folge auf eine Integrationselektrode des jeweiligen Registrierpixels durch an die Fokussierelektroden angelegte Potentiale gelenkt wird, wobei die jeweils vorhergehenden Pixelinformationen bei den nachfolgenden bildgebenden Vorgängen innerhalb der Integrationselektroden erhalten bleiben, werden mehrere Bilder mit verringerter Auflösung nacheinander aufgenommen und im Sensor gespeichert.

Sofern dann das Auslesen der Pixelinformation der nacheinander "belichteten" Integrationselektroden während oder nach Abschluß der bildgebenden Vorgänge erfolgt, kann eine ultrakurze Bildfolgezeit zwischen den Einzelbildern erreicht werden.

Für eine gezielte Meßdatenauswertung ist es vorteilhaft, daß die Pixelinformationen der Integrationselektroden in Reihenfolge und Zeitpunkt gesteuert ausgelesen werden.

Nachfolgend werden Ausgestaltungen der Erfindung anhand der beiliegenden Zeichnungen detailliert beschrieben.

Darin zeigt:
- Fig. 1: im schematisierten Querschnitt eine Halbleiteranordnung zur Bilderfassung ohne (a) und mit (b) Pixelbinning,
- Fig. 2: im Ausschnitt in schematisierter Draufsicht eine Ausgestaltung einer aktiven Halbleiteroberfläche und
- Fig. 3: im schematisierten Querschnitt eine Potentialdarstellung zu einer Halbleiterausgestaltung gemäß Fig. 2.

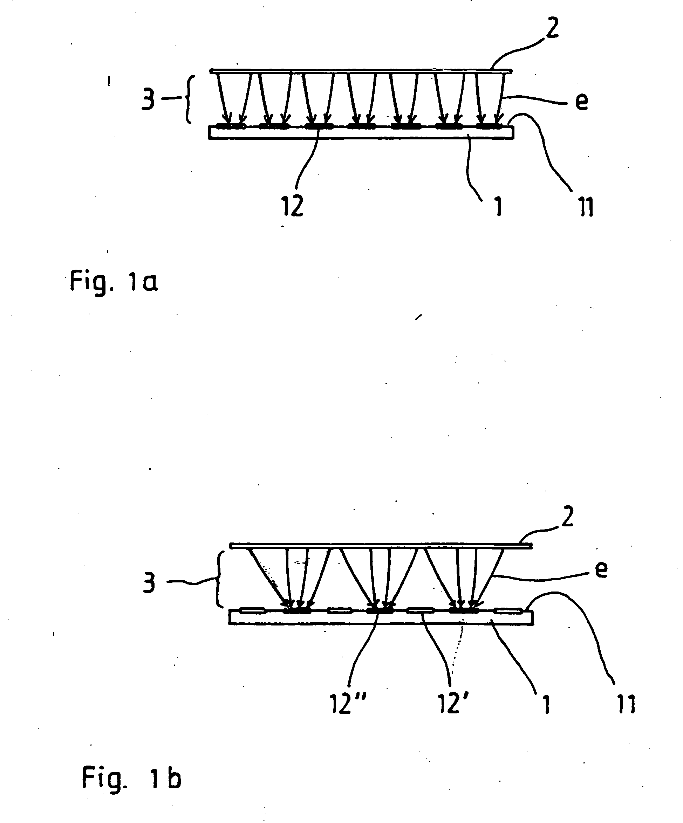

In Fig. 1a ist im Querschnitt eine Anordnung zur Bilderfassung mit einem erfindungsgemäßen Halbleitersensor in einem Vakuum mit Photokathode im Normalbetrieb schematisiert dargestellt.

Die Gesamtanordnung besteht aus einem Halbleitersensor 1, dessen aktive Fläche 11 einer Photokathode 2 gegenübersteht. Zwischen Photokathode 2 und Halbleitersensor 1 ist ein Vakuum 3 ausgebildet.

Bei einer Belichtung der Photokathode 2 werden Elektronen e ausgelöst, die aufgrund des anliegenden Potentialgefälles zwischen Photokathode 2 und aktiver Halbleiteroberfläche 11 von dieser angezogen werden.

Im dargestellten Ausführungsbeispiel besteht die aktive Halbleiteroberfläche 11 aus einer Vielzahl von flächig nebeneinander angeordneten Integrationselektroden 12, die mit der jeweils nachgeschalteten, nicht dargestellten Elektronik einen Pixel bilden. Zum Beginn einer Messung wird über die Elektronik jedem Pixel kurzfristig ein Reset-Potential aufgeprägt. Das die Elektronen e von der Photokathode 2 anziehende Potentialgefälle ergibt sich somit aus dem Potentialunterschied zwischen Photokathode 2 und den Integrationselektroden 12.

Im in Fig. 1a dargestellten Normalzustand sind alle Integrationselektroden 12 des Halbleitersensors 1 zur Aufnahme von Elektronen e aktiv. Das aufgrund des Potentialgefälles im Vakuumraum 3 ausgebildete elektrische Feld ist im wesentlichen homogen. Damit werden die an der Photokathode 2 ausgelösten Elektronen e im wesentlichen auf kürzestem Wege zur gegenüberliegenden Integrationselektrode 12 beschleunigt. Somit wird das auf der Photokathode aufliegende Bild in höchster Auflösung mit jedem einzelnen Pixel des Halbleiters zugeordneten Informationen aufgenommen.

Bei der in Fig. 1b dargestellen Abwandlung wird über eine nicht dargestellte Schalteinheit jede zweite Integrationselektrode 12' an ein festes Potential angelegt, um die von der Photokathode 2 ausgelösten Elektronen e entsprechend des sich zwischen der Photokathode 2 und dem Halbleitersensor 1 im Vakuumraum 3 ausbildenden elektrischen Feldes auf die übrigen, aktiven Integrationelektroden 12" zu lenken. Die Bildinformationen werden somit lediglich auf die Hälfte der Pixel gelenkt. Entsprechend ist die zu verarbeitende Datenmenge halbiert, woraus sich eine höhere Auslesegeschwindigkeit ergibt. Durch die Bündelung der an der Photokathode 2 ausgelösten Elektronen e wird zudem die Empfindlichkeit der Vorrichtung um Faktor 2 erhöht. Die Punktauflösung ist selbstverständlich ebenfalls halbiert.

Dieser bildgebende Halbleitersensor 1 kann somit bedarfsgerecht von einer normalen Verwendung mit maximaler Pixelauflösung auf einen Sensor mit zwar geringerer Auflösung, jedoch höherer Sensitivität und Auslesegeschwindigkeit umgeschaltet werden. Die Bündelung der Elektronen ist je nach geometrischer Ausbildung und entsprechender Beschaltung der Integrationselektroden 12 in aktive Integrationselektroden 12" (Registrierpixel) mit umgebenden Integrationselektroden 12' an festem Potential in weiten Bereichen variierbar. Beispielsweise kann ein Flächenelement von 3 x 3 Pixeln so beschaltet werden, daß nur das zentrale Pixel als aktive Integrationselektrode 12" wirkt und die umgebenden Integrationselektroden 12' aufgrund des festen Potentials einen Potentialtopf zur Bündelung der an der Photokathode 2 ausgelösten Elektronen e bildet.

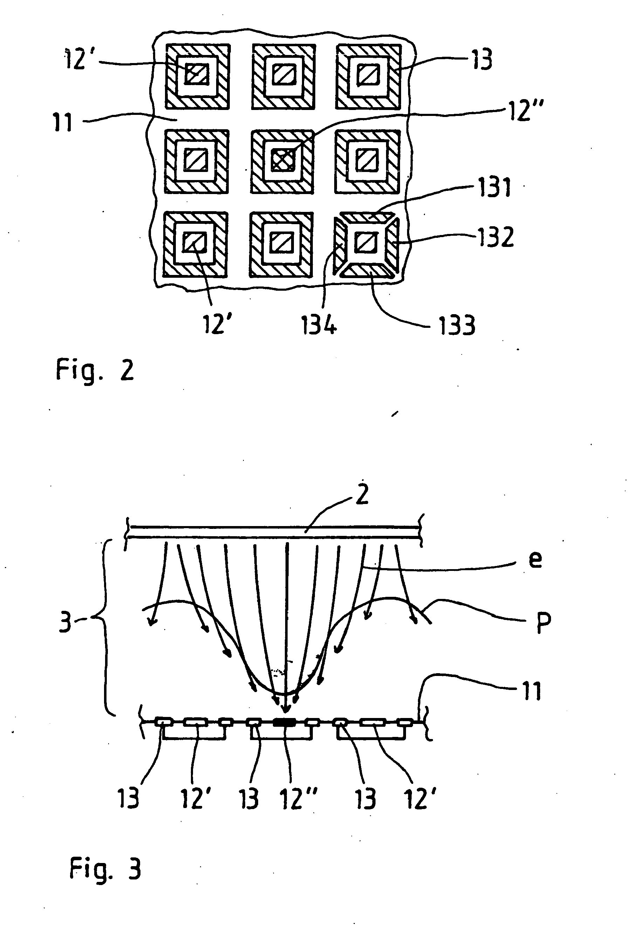

In alternativer oder ergänzender Ausbildung ist in Fig. 2 in Draufsicht auf die aktive Oberfläche 11 ein Halbleitersensor 1 mit Fokussierelektroden 13 schematisiert in einem Ausschnitt dargestellt.

Im dargestellten Ausführungsbeispiel ist zu jeder Integrationselektrode 12 eine diese umgebende Fokussierelektrode 13 an der aktiven Oberfläche 11 des Halbleitersensors 1 ausgebildet. Die Fokussierelektroden 13 sind über entsprechende Wirkverbindungen an der nicht dargestellten Schalteinheit angeschlossen, so daß je nach gewünschtem Bündelungseffekt ein entsprechendes festes Potential an die jeweilige Fokussierelektrode angelegt werden kann.

In weiterer Ausgestaltung kann die eine Integrationselektrode 12 umgebende Fokussierelektrode 13 auch aus untereinander getrennten Fokussierelektrodenelementen bestehen. In Fig. 2 ist beispielhaft bei dem unten rechts darstellten Pixel eine in vier Einzelelemente 131, 132, 133, 134 unterteilte Fokussierelektrode dargestellt. Mit entsprechenden Wirkverbindungen zu der nicht dargestellten Schalteinheit können so unterschiedliche, feste Potentiale an die einzelnen Fokussierelektrodenelemente 131, 132, 133, 134 gelegt werden, um eine besonders geartete Bündelung der Elektronen zu ermöglichen.

Bei der Kombination der in den Patentansprüchen 1 und 2 dargestellten Merkmale in einem Halbleitersensor können neben den Fokussierelektroden 13 auch ausgewählte Integrationselektroden 12' an ein festes Potential gelegt werden. In Fig. 2 ist beispielhaft dargestellt, daß jeweils ein Flächensegment von 3 x 3 Pixeln zur jeweilig zentralen, aktiven Integrationselektrode 12" durch Ausbildung eines entsprechenden elektrischen Feldes im Vakuumraum gestaltet ist.

Zur Verdeutlichung des dabei entstehenden elektrischen Feldes ist in Fig. 3 im Querschnitt die Ausbildung des Potentialtopfes bei einer Ausgestaltung des Halbleitersensors gemäß Fig. 2 schematisiert dargestellt.

Das sich im Vakuumraum 3 zwischen Photokathode 2 und Halbleitersensor 1 ausbildende elektrische Feld ist durch die "Potentiallinie" P visualisiert. Entsprechend werden die von der Photokathode 2 ausgelösten Elektronen e auf den jeweiligen Registrierpixel 12" fokussiert.

In diesem Ausführungsbeispiel wird eine 9-fache Empfindlichkeit der Vorrichtung erreicht. Aufgrund der ebenfalls um den Faktor 9 kleineren Datenmenge ist die Auslesegeschwindigkeit und weitere Datenverarbeitung entsprechend beschleunigt.

In einer Ausgestaltung des Beschaltungsverfahrens ist vorgesehen, daß der Elektronenstrom in einer Bildfolge wie vorgenannt auf jeweils ein Registrierpixel fokussiert wird, wobei von Aufnahme zu Aufnahme die mittels Fokussierelektroden erzeugten Bündelungspotentiale so umgeschaltet werden, daß jeweils ein anderer Registrierpixel zur Elektronenregistrierung fokussiert wird. Entscheidend ist dabei, daß die in den jeweilig vorangegangenen Belichtungszyklen an den jeweiligen Registrierpixeln aufgenommenen Informationen (Ladungen) in der Pixelstruktur gehalten werden. Das heißt, das die jeweiligen Integrationselektroden der bereits "belichteten" Pixel weder mit einem festen Potential noch mit einem Reset-Potential belegt werden. Gleichwohl wird über die um die Integrationselektroden angelegten Fokussierelektroden ein elektrisches Feld aufgebaut, bei dem die zu registrierenden Elektronen am Durchtritt auf die jeweils nicht aktiven Integrationselektroden gehindert werden und auf die jeweilig aktive Integrationselektrode (Registrierpixel) gelenkt werden.

Der große Vorteil dieser besonderen Beschaltungstechnik liegt in der ultraschnellen Bildfolge, bei der Folgezeiten von beispielsweise 10 ns erreicht werden können. Bei einer Beschaltung gemäß Ausführungsbeispiel zu Fig. 2 können beispielsweise 9 Einzelbilder binnen 90 ns aufgenommen werden, bevor der im Vergleich zu dieser Bildfolgezeit erheblich länger dauernde Auslesevorgang zur Weiterverarbeitung aufgenommen Bildinformationen ausgelöst wird.

Mit diesen ultrakurzen Bildfolgezeiten können detaillierte Untersuchungen von schnellen Bewegungsabläufen durchgeführt werden. Beispielsweise können genaue Messungen für Geschwindigkeits- oder Abstandsmessungen durch Laufzeitmessungen von Laserlichtpulsen mit dieser Technik durchgeführt werden.

Mit den erfindungsgemäßen Halbleitersensoren bzw. dem erfindungsgemäßen Beschaltungsverfahren besteht die variable Möglichkeit Pixel zusammenzufassen, um die Sensitivität oder Auslesegeschwindigkeit zu erhöhen. Bei Halbleitersensoren mit Fokussierelektroden kann der Potentialverlauf zwischen Anode (Halbleiter) und Kathode zusammen mit dem Reset-Potential der aktiven Integrationselektroden (Registrierpixeln) beeinflußt werden. Beim Normalbetrieb ist jede Integrationselektrode (Pixel) des Halbleiters aktiv. Beim Binning wird jedoch das Spannungspotential der Fokussierelektroden und Integrationselektroden so eingestellt, daß der Elektronenfluß von der Kathode nur bestimmte Bereiche der Halbleiteroberfläche erreicht. Wie bereits zu den Ausführungsbeispielen zu Fig. 1 und 2 dargestellt, reduziert sich somit die Anzahl der aktiven Pixel (Registrierpixel), wobei die von der Kathode ausgelösten Elektronen auf diese Registrierpixel gebündelt werden, womit sich die Sensitivität (Anzahl von eintreffenden Elektronen je Pixel) erhöht.

Berechnungen haben ergeben, daß der Halbleitersensor für eine Detektion von unter 100 Elektronen pro Pixel ausgelegt werden kann. Daraus ergeben sich für die Konversionzelle ein Signal-/Rauschen-Verhältnis besser als 4,5 dB. Somit reicht die Sensitivität des Halbleitersensors für einen Einsatz unter schlechtesten Beleuchtungsverhältnissen aus.

Darüber hinaus kann durch das Halten und "Abschatten" von aufgenommenen Pixelinformationen ultrakurze Belichtungsfolgezeiten erreicht werden, wobei die Informationsauslesung nach Ablauf der Belichtungsserie erfolgt.

Insgesamt erfüllen die zwischen den Pixeln angeordneten Fokussierelektroden mehrere Funktionen. Einerseits ermöglichen Sie das Integrieren von Elektronenfluß auf ein Registrierpixel (Binning), andererseits verhindern sie auch das Überlaufen (Blooming) von Ladungsträgern in Nachbereiche und erlauben bedarfsweise das "Abschatten" von aufgenommen Pixelinformationen.

Ferner ist herauszustellen, daß in Verbindung mit dem elektrischen Feld zwischen Anode (Integrationselektrode) und Kathode sich eine Sensitivitätscharakteristik mit sehr hohem Dynamikbereich ergibt, da mit steigenden Signalpegeln auf der Kathode die Anzahl der emittierten Elektronen steigt. Diese akkumulieren sich auf der Anode und führen zu einer lokalen Potentialveränderung. Diese bewirkt bei hohen Signalhüben eine lokale Reduktion der Spannung zwischen Anode und Kathode und somit eine lokale Reduktion der Auslösefähigkeit der Elektronen aus der Kathode. Diese nicht lineare Charakteristik bei hohen Signalpegeln verbessert das Detektionsverhalten des Sensors bei hohen Kontrasten, beispielsweise Gegenlicht eines entgegenkommenden Fahrzeugs mit eingeschalteter Beleuchtung in einem dunklen Tunnel.

### Bezugszeichenliste

- 1: Halbleitersensor
- 11: Aktive Oberfläche
- 12: Integrationselektrode
- 12': Integrationselektrode an festem Potential
- 12": Aktive Integrationselektrode (Registrierpixel)
- 13: Fokussierelektrode
- 131: Fokussierelektrodenelement
- 132: Fokussierelektrodenelement
- 133: Fokussierelektrodenelement
- 134: Fokussierelektrodenelement

- 2: Photokathode

- 3: Vakuumraum

- e: Elektron

- P: Potentiallinie

## Patentansprüche

1. Verfahren zur Beschaltung eines Halbleitersensors(1) mit einer Pixelstruktur, wobei jeder Pixel eine Integrationselektrode (12) hat, zu jedem Pixel eine Kapazität ausgebildet ist, die Ladung speichert und in auslesbare Spannung konvertiert, und der Sensor (1) zum unmittelbaren Detektieren von Elektronen (e) ausgebildet ist, **dadurch gekennzeichnet, daß** zur Bündelung der zu detektierenden Elektronen (e) auf bestimmte Integrationselektroden (Registrierpixel) (12") im wesentlichen ringförming um eine oder mehrere Integrationselektroden (13) und eine Schalteinheit mit Ausgängen, die mit den Fokussierelektroden (13) verbunden sind, vorgesehen sind, womit ein einstellbar Konstantes oder festes Potential über die Ausgänge der Schalteinheit auf den Fokussierelektronen (13) angelegt werden kann.

2. Verfahren zur Beschaltung eines Halbleitersensors (1) mit einer Pixelstruktur, wobei jeder Pixel eine Integrationselektrode (12) hat, zu jedem Pixel eine Kapazität ausgebildet ist, die Ladung speichert und in auslesbare Spannung konvertiert, und der Sensor (1) zum unmittelbaren Detektieren von Elektronen (e) ausgebildet ist, **dadurch gekennzeichnet, daß** Fokussierelektroden (13). Zur Bündelung der zu detektierenden Elektronen (e) auf bestimmte Integrationselektroden (Registrierpixel) (12") in wesentlichen ringförming um eine oder mehrere Integretionselektroden (13) und eine Schalteinheit mit Ausgängen, die mit den Fokussierelektroden (13) verbunden sind, vorgesehen sind, womit ein einstellbar Konstantes oder festes Potential über die Ausgänge der Schalteinheit auf den Fokussierelektronen (13) angelegt werden kann.

3. Verfahren nach Anspruch 1 oder 2, **dadurch gekennzeichnet, daß** die Fokussierelektroden (13) und/oder Integrationselektroden (12') mit der Schalteinheit derart verbunden sind, daß bedarfsweise unterschiedliche Potentiale an die Fokussierelektrode (13) bzw. Integrationselektroden (12') angelegt werden können.

4. Verfahren sensor nach Anspruch 2 oder Anspruch 2 mit 3, **dadurch gekennzeichnet, daß** die Fokussierelektrode (13) mehrteilig ausgebildet ist und jedes Fokussierelektrodenelement (131, 132, 133, 134) mit einem Ausgang der Schalteinheit zur getrennten Beschaltung verbunden ist.

5. Verfahren nach Anspruch 2 oder Anspruch 2 mit 3 oder 4, **dadurch gekennzeichnet, daß** mehrere Fokussierelektroden (13) konzentrisch um einen oder mehrere Integrationselektroden (12) angeordnet sind.

6. Verfahren nach einem der Ansprüche 1, 3 bis 5, **dadurch gekennzeichnet, daß** an ausgewählte Integrationselektroden einer vorher festgelegten Umgebung eines Pixels feste Potentiale angelegt werden, so daß der zu detektierende Elektronenfluß nur vorbestimmte Integrationselektroden (Registrierpixel) des Halbleitersensors erreicht, wobei der zu detektierende Elektronenfluß, der auf die vorher festgelegte Umgebung eines Pixels gerichtet ist, durch an die Fokussierelektroden angelegte feste Potentiale auf einem dieser Umgebung zugeordneten Registrierpixel gesammelt wird.

7. Verfahren nach einem der Ansprüche 2 bis 5, **dadurch gekennzeichnet, daß** an die Fokussierelektroden feste Potentiale angelegt werden, so daß der zu detektierende Elektronenfluß nur vorbestimmte Integrationselektroden (Registrierpixel) des Halbleitersensors erreicht, wobei der zu detektierende Elektronenfluß, der auf die vorher festgelegte Umgebung eines Pixels gerichtet ist, durch an die Fokussierelektroden angelegte feste Potentiale auf einem dieser Umgebung zugeordneten Registrierpixel gesammelt wird.

8. Verfahren nach Anspruch 6 oder 7, **dadurch gekennzeichnet, daß** vor dem Detektieren von Elektronen die integrationselektroden mit einem Reset-Potential geladen werden.

9. Verfahren nach Anspruch 6, 7 oder 8, **dadurch gekennzeichnet, daß** an die zur festgelegten Umgebung des Registrierpixels gehörenden Integrationselektroden der angrenzenden Pixel ein festes Potential angelegt wird.

10. Verfahren nach Anspruch 6, 7 und 8, **dadurch gekennzeichnet, daß** der zu detektierende Elektronenfluß innerhalb einer festgelegten Anzahl und Anordnung benachbarter Pixel je bildgebendem Vorgang in zeitlicher Folge auf eine Integrationselektrode des jeweiligen Registrierpixels durch an die Fokussierelektroden angelegte Potentiale gelenkt wird, wobei die jeweils vorhergehenden Pixelinformationen bei den nachfolgenden bildgebenden Vorgängen innerhalb der Integrationselektroden erhalten bleiben.

11. Verfahren nach Anspruch 10, **dadurch gekennzeichnet, daß** das Auslesen der Pixelinformation der nacheinander "belichteten" Integrationselektroden während oder nach Abschluß der bildgebenden Vorgänge erfolgt.

12. Verfahren nach einem der Ansprüche 6 bis 11, **dadurch gekennzeichnet, daß** die Pixelinformationen der Integrationselektroden in Reihenfolge und Zeitpunkt gesteuert ausgelesen werden.

## Claims

1. Method to handle a semiconductor sensor (1) with a pixel structure, on which each pixel has an integration electrode (12) with a capacitance being applied to each pixel that stores charge and converts it into readable voltage, and the sensor (1) being designed for direct detection of electrons (e), **characterized by** the possibility to achieve a binning of the electrons that are to be detected on particular integration electrodes (12") (registration pixel) by a switching unit whose outputs deliver an adjustable constant or fix voltage on at least some preassigned integration electrodes (12').

2. Method to handle a semiconductor sensor (1) with a pixel structure, on which each pixel has an integration electrode (12), with a capacitance being applied to each pixel that stores charge and converts it into readable voltage, and the sensor being designed for direct detection of electrons (e), **characterized by** mainly ring-like arranged focus electrodes (13) around one or more integration electrodes for binning and focussing electrons (e) to dedicated integration electrodes (12") (registration pixel) by a switching unit whose outputs deliver an adjustable constant or fix voltage onto the focus electrodes (13).

3. Method according to claim 1 or 2, **characterized by** the focus electrodes (13) and/or the integration electrodes (12') being connected to the switching unit in such a way that, if necessary, different potentials can be applied to the focus electrode (13) respectively the integration electrodes (12').

4. Method according to claim 2 or claim 2 together with claim 3, **characterized by** a multi-sectional focus electrode (13) so that each focus electrode element (131, 132, 133, 134) is connected to an separate controllable output of the switching unit.

5. Method according to claim 2 or claim 2 together with claims 3 or 4, **characterized by** several focus electrodes (13) being arranged concentrically around one or more integration electrodes (12).

6. Method according to claims 1, 3, 4 and 5, **characterized by** applying different fix voltages to the surrounding of especially selected integration electrodes in order to focus the electrons (which have to be detected) to dedicated integration electrodes (registration pixels) while electrons which without this procedure would be directed to the surrounding of registration pixels are directed to preassigned registration pixels by supplying fixed voltages to the focus electrodes (13).

7. Method according to claims 2 to 5, **characterized by** applying different fix voltages to focussing electrodes in order to focus the electrons (which have to be detected) to dedicated integration electrodes (registration pixels) while electrons which without this procedure would be directed to the surrounding of registration pixels are directed to preassigned registration pixels by supplying fixed voltages to the focus electrodes (13).

8. Method according to claim 6 or 7, **characterized by** a precharging of the integration electrodes with a reset-potential before the detection of electrons.

9. Method according to claim 6, 7 or 8, **characterized by** supplying a fix voltage to preassigned integration electrodes in the surrounding of a registration pixel.

10. Method according to claim 6, 7, and 8, **characterized by** the sequential guidance of the electron flow that is to be detected per image acquisition sequence within a determined number and assembly of neighbouring pixels onto an integration electrode of the respective registration pixel while holding the respective pixel information within the integration electrodes for following image acquisitions.

11. Method according to claim 10, **characterized by** the read-out of the pixel information of the sequentially 'exposed' integration electrodes happening while or after the image acquisitions.

12. Method according to one of the claims 6 to 11, **characterized by** a controlled read-out of the integration electrodes' pixel information in sequence and time.

## Revendications

1. Procédure de manipulation d'un détecteur à semi-conducteur doté d'une structure pixel. Chaque pixel comprend une électrode d'intégration, une capacitance qui mémorise les charges et les convertit en tension lisible. Le dispositif de détection peut détecter directement des électrons. Le détecteur à semi-conducteur est **caractérisé par** sa capacité de concentrer les électrons à détecter sur des électrodes d'intégration déterminées (12") (pixel d'enregistrement), grâce à l'installation d'une unité de contrôle dont les sorties sont connectées à, au moins, quelques électrodes d'intégration prédéterminées, permettant d'appliquer un potentiel réglable ou fixe à travers les sorties de l'unité de contrôle sur des électrodes d'intégration sélectionnées.

2. Procédure de manipulation d'un détecteur à semi-conducteur doté d'une structure pixel. Chaque pixel comprend une électrode d'intégration, une capacitance qui mémorise les charges et les convertit en tension lisible. Le dispositif de détection étant en mesure de détecter directement des électrons. Le détecteur à semi-conducteur est **caractérisé par** sa capacité de concentrer les électrons à détecter sur des électrodes d'intégration déterminées (pixel d'enregistrement)(12") avec électrodes de focalisation (13), grâce à l'installation annulaire d'une unité de contrôle dont les sorties sont connectées à des électrodes de focalisation permettant d'appliquer un potentiel réglable ou fixe à travers les sorties de l'unité de contrôle sur les électrodes de focalisation (13).

3. Procédure selon demande 1 ou 2, **caractérisée par le fait que** les électrodes de focalisation et/ou les électrodes d'intégration sont connectées à l'unité de contrôle de manière à pouvoir appliquer, si besoin, des potentiels variés aux électrodes de focalisation ou aux électrodes d'intégration.

4. Procédure selon demande 2 ou demande 2 avec 3, **caractérisée par le fait que** l'électrode de focalisation est composée de plusieurs parties et que chaque élément de l'électrode de focalisation (131, 132, 133, 134) est connecté à une sortie séparée de l'unité de contrôle.

5. Procédure selon demande 2 ou demande 2 avec 3 ou 4, **caractérisée par le fait que** plusieurs électrodes de focalisation sont installées de facon concentrique autour d'une ou plusieurs électrodes d'intégration.

6. Procédure selon une des demandes 1, 3 à 5, **caractérisé par** l'application de potentiels fixes sur des électrodes d'intégration déterminés d'un environnement d'un pixel déterminé antérieurement. Par conséquent, le flux d'électrons à détecter n'atteint que des électrodes d'intégration prédéterminées (pixel d'enregistrement) du détecteur à semi-conducteur. En même temps, le flux d'électrons à déterminer visant un environnement prédéterminé d'un pixel est dirigé vers l'un des pixel d'enregistrement grâce à l'application de potentiels fixes aux électrodes de focalisation.

7. Procédure selon l'une des demandes 2 à 5, **caractérisée par** l'application de potentiels fixes aux électrodes de focalisation pour diriger le flux d'électons à détecter vers des électrodes d'intégration prédéterminés du détecteur à semi-conducteur. Le flux d'électrons à détecter dirigé sur l'environnement d'un pixel d'enregistrement est guidé vers un des pixel d'enregistrement affecté à cet environnement, grâce à l'application de potentiels fixes aux électrodes de focalisation.

8. Procédure selon demande 6 ou 7, **caractérisée par le fait que** les électrodes d'intégration sont chargées avec un potentiel « reset » avant de détecter des électrons.

9. Procédure selon demande 6, 7 ou 8, **caractérisée par le fait qu'**un potentiel fixe est appliqué aux électrodes d'intégration prédéterminées dans l'environnement du pixel d'enregistrement.

10. Procédure selon demande 6, 7 et 8, **caractérisée par le fait que** le flux d'électrons à détecter est guidé de façon séquentielle sur une électrode d'intégration du pixel d'enregistrement en question à l'aide de potentiels appliqués aux électrodes de focalisation, tout en respectant un nombre particulier et une série déterminée des pixels avoisinants pour chaque procédure d'image. Les informations pixel de l'image précédente sont mémorisées à l'intérieur des électrodes d'intégration pendant les prochaines procédures de génération d'images.

11. Procédure selon demande 10, **caractérisée par le fait que** l'extraction des informations pixel des électrodes d'intégration « exposées » de facon consécutive est effectuée pendant ou après les procédures de génération d'images.

12. Procédure selon l'une des demandes 6 à 11, **caractérisée par le fait que** les informations pixel des électrodes d'intégration sont extraites en tenant compte de la séquence et du temps.
